# EUROPEAN PATENT APPLICATION

(11) **EP 1 921 907 A2**
(43) Date of publication of application: **14.05.2008**
(21) Application number: 07251965.5
(22) Date of filing: 11.05.2007
(51) Int. Cl.: H05K 5/02

(54) **Plasma display device with partly rigid and partly flexible connection between the display panel and the circuit board**

(30) Priority: 08.11.2006 KR 20060109960
(71) Applicant: Samsung SDI Co., Ltd., Suwon-si, Gyeonggi-do (KR)
(72) Inventor: Chung, Moo-il, Kyunggi-do (KR)
(74) Representative: Mounteney, Simon James

(57) **Abstract**

A plasma display device having improved connection reliability between display electrodes of a plasma display panel and printed circuit boards, thereby reducing electromagnetic interference (EMI) noise, and reducing cost due to reduction of the number of components is disclosed. The plasma display device includes a partly rigid and partly flexible printed circuit board which is mounted on the chassis base and is connected to display electrodes of the plasma display panel.

## Description

### BACKGROUND OF THE INVENTION

### Field of the Invention

The present invention relates to a plasma display device, and more particularly, to a plasma display device capable of improving connection reliability between display electrodes of a plasma display panel and a partly rigid and partly flexible printed circuit board by connecting the partly rigid and partly flexible printed circuit board to the display electrodes, thereby reducing electromagnetic interference (EMI) noise, and reducing cost due to a reduction of the number of components.

### Description of the Related Technology

Generally, a plasma display device includes a plasma display panel for displaying an image, a chassis base which is fixed to the plasma display panel to support the plasma display panel, and a plurality of printed circuit boards which are mounted on the chassis base and electrically connected to the plasma display panel.

The plasma display panel generates plasma through gas discharge and excites a phosphors by using vacuum ultra-violet (VUV) radiation emitted from the plasma, thereby displaying an image by using visible light of red (R), green (G), and/or blue (B) obtained by stabilizing the excited phosphors.

Since the plasma display panel includes two facing glass substrates sealed together and including address electrodes and display electrodes which cross each other corresponding to discharge cells, the plasma display panel has weak mechanical rigidity with respect to an external impact. Accordingly, the chassis base is made of metal of which mechanical strength is greater than that of the glass substrates in order to support the plasma display panel.

The chassis base has the functions of supplying a space for mounting the printed circuit boards, dissipating heat of the plasma display panel, and grounding electromagnetic interference (EMI), in addition to the function of supplying the mechanical rigidity for supporting the plasma display panel.

In order to perform the aforementioned functions, the plasma display panel is fixed to a front surface of the chassis base by interposing a double sided tape therebetween. The printed circuit boards are mounted on a rear surface of the chassis base.

A plurality of bosses are formed on the rear surface of the chassis base, the printed circuit boards are disposed on the bosses, and set screws are engaged to the bosses through the printed circuit boards. Accordingly, the printed circuit boards are mounted on the chassis base.

The plasma display device includes the plurality of printed circuit boards in order to perform functions for driving the plasma display panel. Specifically, the printed circuit boards include a sustain board for controlling sustain electrodes, a scan board for controlling scan electrodes, and an address buffer board for controlling address electrodes.

Display electrodes of the plasma display panel include the sustain electrodes and the scan electrodes. The sustain electrodes are supplied with a common sustain voltage. However, the scan electrodes are each supplied with scan voltages, respectively. The scan voltages are generated in the scan integrated circuit (IC) and sequentially applied to the scan electrodes. Accordingly, the scan board includes a separate scan buffer board. The scan buffer board includes the scan IC.

In addition, the printed circuit boards include an image processing/control board which receives image signals from the outside of the plasma display device and generates control signals for driving the address electrodes and control signals for driving the sustain and scan electrodes to apply the control signals to the corresponding boards. The printed circuit boards include a power board for supplying power needed for driving the aforementioned boards.

The sustain board is connected to the sustain electrodes, which extend out from the inside of the plasma display panel, through a flexible printed circuit (FPC) and a connector. The scan board is connected to the scan electrodes, which extend out from the inside of the plasma display panel, through an FPC and a connector. The scan board is connected to the scan buffer board through an FPC and a connector, or through a cable and a connector.

In the plasma display device, engaging defects between connectors may be caused by dusts or impurities. Accordingly, it is difficult to secure connection reliability between the plasma display panel and the sustain and scan boards and between the scan board and the scan buffer board. EMI noise may occur, and cost increases due to increase of the number of components.

### SUMMARY OF CERTAIN INVENTIVE ASPECTS

The present invention provides a plasma display device capable of improving connection reliability between display electrodes of a plasma display panel and a partly rigid and partly flexible printed circuit board by connecting the partly rigid and partly flexible printed circuit board to the display electrodes, reducing electromagnetic interference (EMI) noise, and reducing cost due to reduction of the number of components.

According to a first aspect of the invention, there is provided a plasma display device as set out in claim 1. Preferred features of this aspect are set out in claims 2-12.

According to a second aspect of the invention, there is provided a plasma display device as set out in claim 13. Preferred features of this aspect are set out in claims 14 to 20.

### BRIEF DESCRIPTION OF THE DRAWINGS

Embodiments of the invention will be described by way of example and with reference to the accompanying drawings:
FIG. 1 is a perspective view schematically illustrating a plasma display device by exploding the plasma display device according to an embodiment of the invention;
FIG. 2 is a top plan view illustrating a connection state between a partly rigid and partly flexible printed circuit board and display electrodes of a plasma display panel viewed from a rear surface direction of the plasma display panel;
FIG. 3 is a cross sectional view of the printed circuit board taken along line III-III of FIG. 2;
FIG. 4 is a perspective view illustrating a partly rigid and partly flexible printed circuit board;
FIG. 5 is a perspective view illustrating a rigid circuit board and a flexible circuit board by exploding the partly rigid and partly flexible printed circuit in FIG. 4;
FIG. 6 is a cross sectional view of the printed circuit board taken along line IV-IV of FIG. 5; and
FIG. 7 is a cross sectional view of the printed circuit board taken along line VII-VII of FIG. 5.

### DETAILED DESCRIPTION OF CERTAIN INVENTIVE EMBODIMENTS

Certain embodiments will now be described more fully hereinafter with reference to the accompanying drawings. As those skilled in the art would realize, the described embodiments may be modified in various different ways, without departing from the scope of the present invention.

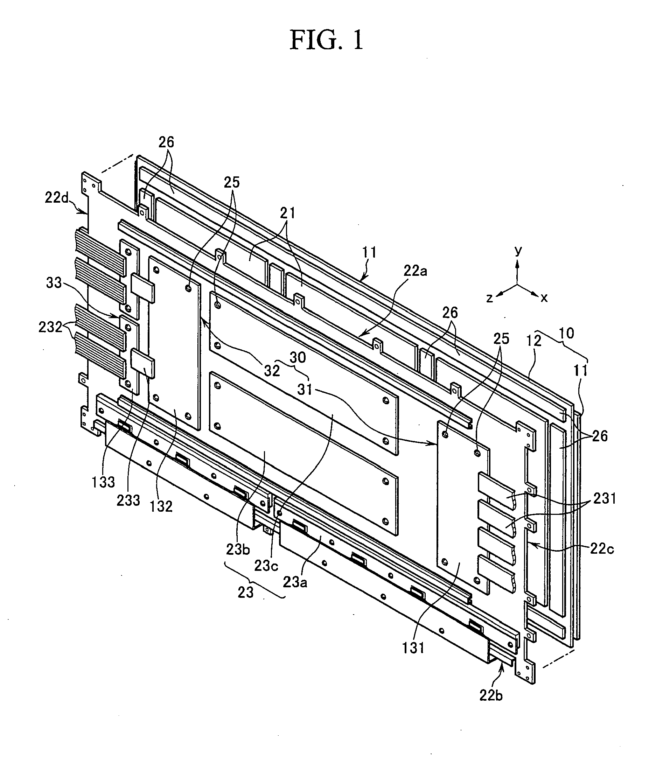

FIG. 1 is an exploded perspective view schematically illustrating a plasma display device. Referring to FIG. 1, the plasma display device includes a plasma display panel 10 for displaying an image using gas discharge, heat dissipating sheets 21, a chassis base 22, printed circuit boards 23, and partly rigid and partly flexible printed circuit boards 30.

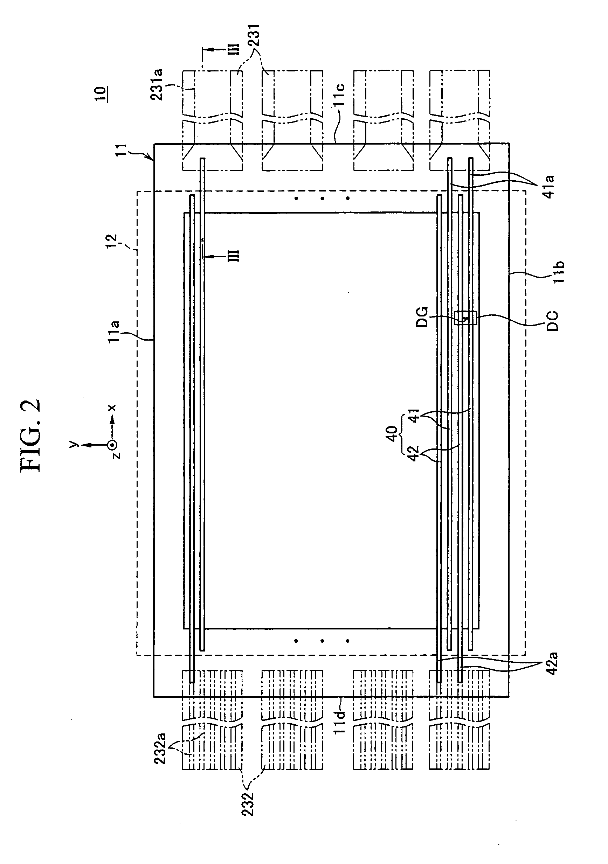

The plasma display panel 10 is formed by sealing two substrates, for example, a front substrate 11 and a rear substrate 12, which are spaced apart from each other by a certain distance. Referring to FIG. 2, the plasma display panel 10 has a generally rectangular shape with two facing long sides (which extend in a first or x direction) and two facing short sides (which extend in a second or y direction) substantially perpendicular to the long sides, with the sides located in a xy-plane. The rear substrate 12 is illustrated by using a dotted line. The front substrate 11 includes two long sides 11 a and 11 b and two short sides 11 c and 11 d respectively perpendicular to the long sides 11 a and 11 b.

The plasma display panel 10 includes display electrodes 40 and address electrodes (not shown) which cross each other for gas discharge. Discharge cells DC are disposed at locations where the display electrodes 40 cross the address electrodes. The display electrodes 40 include sustain electrodes 41 and scan electrodes 42 which face each other in the discharge cell DC. Discharge gaps DGs are formed between the sustain electrodes 41 and the scan electrodes 42.

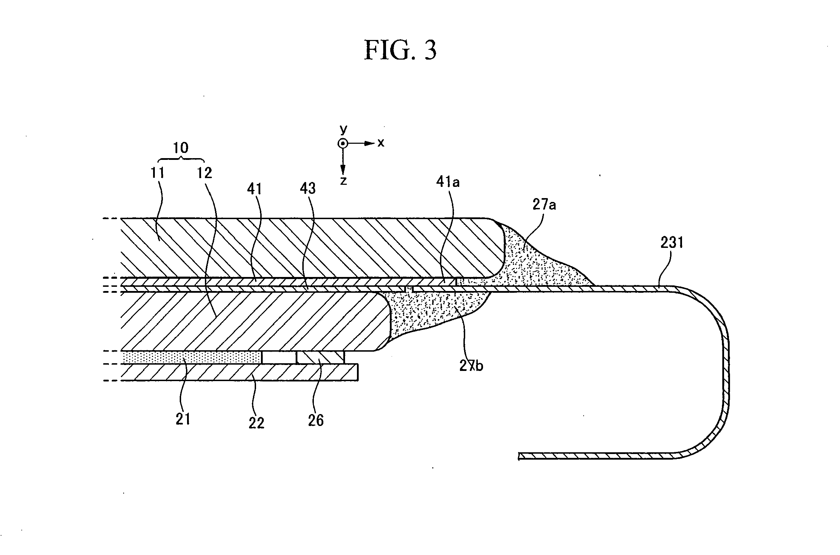

Referring to FIG. 3, the display electrodes 40 are disposed between the front substrate 11 and the rear substrate 12. More specifically, the display electrodes 40 are formed on inner surface of the front substrate 11 and are covered with a dielectric layer 43. For convenience, in FIG. 3, some components, such as the discharge cells DC and the address electrodes are omitted.

The sustain electrodes 41 and the scan electrodes 42 extend in the x-axis direction in parallel with the long sides 11 a and 11 b of the front substrate 11. The sustain electrodes 41 and the scan electrodes 42 form discharge gap DGs therebetween along the y-axis direction. The sustain electrodes 41 extend further towards one short side 11 c of the short sides 11 c and 11 d to be connected to terminals 41 a formed on an end of the front substrate 11 that is near the short side 11c. The scan electrodes 42 extend further towards the other short side 11 d to be connected to terminals 42a formed on an end of the front substrate 11 that is near the short side 11 d.

Referring to FIGs. 1 and 3, again, the heat dissipating sheets 21 are included on the rear substrate 12 of the plasma display panel 10. Accordingly, heat generated in the plasma display panel 10 due to gas discharge is conducted and diffused by the heat dissipating sheets 21. In order to conduct and diffuse the heat generated in the plasma display panel 10, the heat dissipating sheets 21 may be made of, for example, an acrylic heat dissipating material, a graphite heat dissipating material, a metallic heat dissipating material, or a carbon nano tube heat dissipating material. Other materials may also be used. In FIG. 3, although the heat dissipating sheet 21 is illustrated to be adhered to the chassis base 22, a minute space (not shown) may be formed therebetween. Accordingly, most of the heat generated in driving the plasma display panel 10 diffuses and radiates through the heat dissipating sheets 21. In other embodiments, a single heat dissipating sheet 21 could be provided.

The chassis base 22 including the heat dissipating sheets 21 on the front surface thereof is adhered to the rear substrate 12 of the plasma display panel 10 using a double sided tape 26 to support the plasma display panel 10, though in other embodiments alternative methods of fixing could be used. In addition, the chassis base 22 includes the printed circuit boards 23 and the partly rigid and partly flexible printed circuit boards 30 on the opposite side of the plasma display panel 11, that is to say, on the rear surface of the chassis base 22. Accordingly, the chassis base 22 has enough mechanical rigidity to support the plasma display panel 11 on the front surface thereof and to support the printed circuit boards 23 and the partly rigid and partly flexible printed circuit boards 30 on the rear surface thereof.

In general, the plasma display device may include a plurality of printed circuit boards in order to drive the plasma display panel.

The plasma display device according to the illustrated embodiment includes the plurality of partly rigid and partly flexible printed circuit boards 30. Although all the printed circuit boards may be formed as the partly rigid and partly flexible printed circuit boards 30 in order to control the plasma display panel in other embodiments, in the illustrated embodiment, a part of the printed circuit boards are formed as the partly rigid and partly flexible printed circuit boards 30.

In this embodiment, an address buffer board 23a, an image processing/control board 23b, and a power board 23c are formed as the printed circuit boards 23. The sustain board 31 and the scan board 32 are formed as the partly rigid and partly flexible printed circuit boards 30. Therefore, in this embodiment the partly rigid and partly flexible printed circuit boards 30 and the sustain board 31 and the scan board 32are described. However, embodiments of the invention are not limited in this way.

Referring to FIGs. 1 and 2, one side of the sustain board 31 is connected to the terminals 41a of the sustain electrodes 41 to apply a driving voltage to the sustain electrodes 41. One side of the scan board 32 is connected to the terminals 42a of the scan electrodes 42 to apply driving voltages to the scan electrodes 42. In addition, the sustain board 31 and the scan board 32 may be mounted on different sides of the chassis base 22.

For convenience of description, the chassis base 22 is first described. The chassis base 22 has a rectangular plate shape including two facing long sides 22a and 22b and two facing short sides 22c and 22d that are perpendicular to the long sides 22a and 22b.

Accordingly, the long sides 11 a and 11 b of the front substrate 11 of the plasma display panel 10 correspond to the long sides 22a and 22b of the chassis base 22. The short sides 11 c and 11 d of the front substrate 11 correspond to the short sides 22c and 22d of the chassis base 22.

Referring to the embodiment of FIG. 1, the sustain board 31 is mounted on a short side 22c of the chassis base 22, and the scan board 32 is mounted on the other short side 22d of the chassis base 22. The sustain board 31 includes a rigid circuit 131 mounted on the chassis base 22 (refer to FIG. 1) and a flexible circuit 231 connected to the sustain electrodes 41 (refer to FIG. 3).

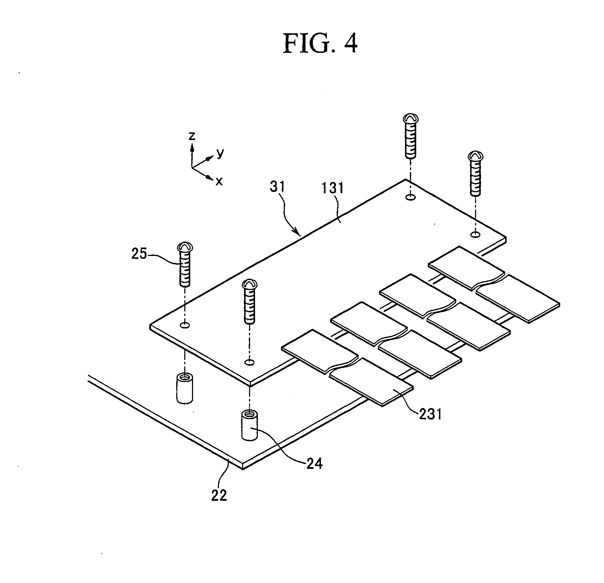

Referring to FIG. 4, the rigid circuit 131 of the sustain board 31 is disposed on bosses 24 on the chassis base 22 and fixed by set screws 25 to be engaged with the bosses 18. The flexible circuit 231 is connected to the rigid circuit 131 and to the sustain electrodes 41.

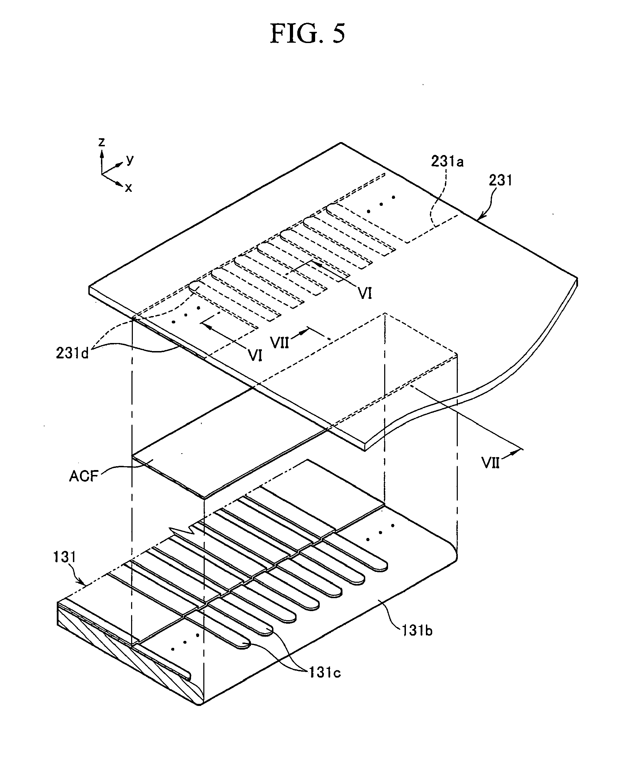

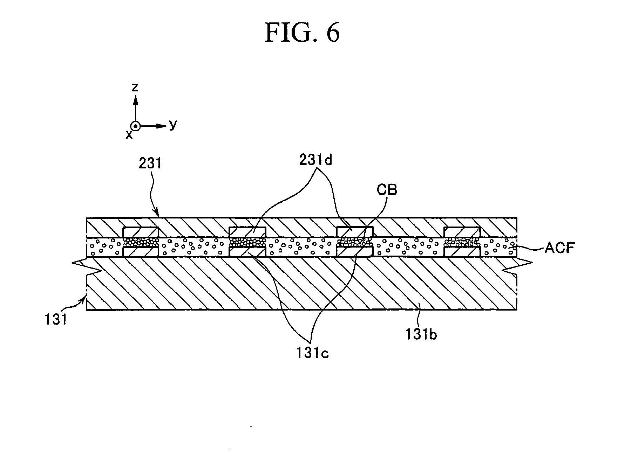

Referring to FIGs. 5 and 6, the rigid circuit 131 includes a substrate 131 b on which a circuit pattern 131 a is formed and rigid terminals 131 c which are connected to the circuit pattern 131 a are exposed at an end of the substrate 131 b. The substrate 131 b is disposed parallel to the plasma display panel 10, the rigid terminals 131 c are formed on an end of the plasma display panel 10.

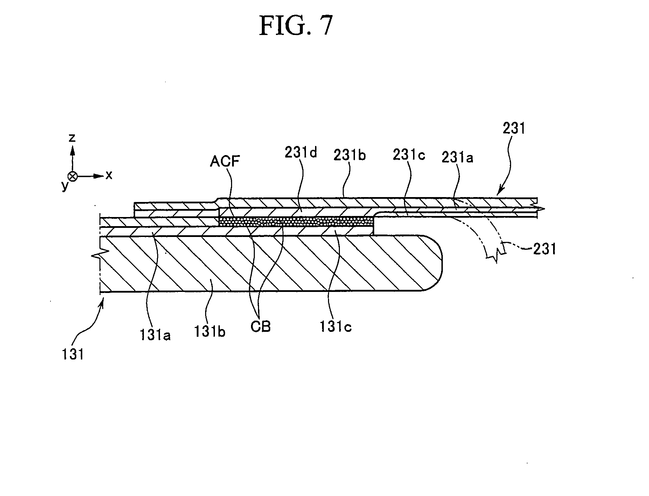

Referring to FIG. 7, the flexible circuit 231 includes two films 231 b and 231 c between which a first circuit pattern 231 a is formed and flexible terminals 231 d which are connected to the first circuit pattern 231 a to be exposed to one film 231 b. The flexible terminals 231 d face the rigid terminals 131 c.

In addition, in the plasma display panel 10, since the common voltage is applied to the sustain electrodes 41, the first circuit pattern 231a has a structure to be connected to the plurality of sustain electrodes 41. Specifically, the flexible circuit 231 includes the first circuit pattern 231 a. The plurality of sustain electrodes 41 are connected to the first circuit pattern 231 a. The rigid circuit 131 is connected to the plurality of flexible circuits 231 each of which includes the first circuit pattern 231 a (refer to FIGs. 1, 2, and 4).

The rigid circuit 131 and the flexible circuit 231 are connected to each other through the rigid terminals 131 c and the flexible terminals 231 d. The rigid terminals 131 c and the flexible terminals 231 d have a pitch P and face each other (refer to FIGs. 5 and 6). The rigid terminals 131c and the flexible terminals 231 d are connected to each other by using conductive balls CBs which are, in some embodiments, densely disposed therebetween (refer to FIGs. 6 and 7). The conductive balls CBs which connect the facing rigid terminals 131 c and the flexible terminals 231 d with a fine pitch may be, for example, an anisotropic conductive film (ACF).

The rigid circuit 131 of the sustain board 31 is mounted on the rear surface of the chassis base 22 at the short side 22c. The flexible circuit 231 is connected to the sustain electrodes 41 of the plasma display panel 10. Accordingly, as shown in FIG. 3, the flexible circuit 231 maintains a bent state in the plasma display device. In other words, it bends from the rigid circuit 131 around to the sustain electrodes 41. In addition, as shown in FIG. 7, a bending force acts on the flexible circuit 231 towards the rigid circuit 131. The circuit pattern 231a of the flexible circuit 231 can be protected by preventing the interference between the bended flexible circuit 231 and the rigid circuit 131. Accordingly, an end of the rigid circuit 131 has a curved shape. This can prevent damage to the flexible circuit 231.

In the aforementioned partly rigid and partly flexible printed circuit board 30, the sustain board 31 is formed as one body by connecting the rigid circuit 131 to the flexible circuit 23. Therefore, when the plasma display device is assembled, a connection operation between the rigid circuit 131 and the flexible circuit 231 is unnecessary and the number of components is reduced by not requiring connectors.

Since the sustain electrodes 41 and the rigid circuit 131 of the sustain board 31 are connected to each other as one body without an additional connection operation, the connection reliability between the sustain electrodes 41 and the rigid circuit 131 is improved, and the EMI noise is reduced by removing the connectors from which impurities are introduced and the EMI noise would otherwise be generated.

Referring to FIG. 3, first and second sealing members 27a and 27b are formed on the contact portions between the terminals 41 a of the sustain electrode 41 and the flexible circuit 231. The space between the short side 11 c of the front substrate 11 and one surface of the flexible circuit 231 near the short side 11 c is filled with the first sealing member 27a. Accordingly, the first sealing member 27a prevents impurities and moisture from being introduced into the contact portion between the short side 11 c and the surface of the flexible circuit 231. The space between a short side of the rear substrate 12 and the other surface of the flexible circuit 231 near the short side is filled with the second sealing member 27b. Accordingly, the second sealing member 27b prevents impurities and moisture from being introduced into the contact portion between the short side and the other surface of the flexible circuit 231. The first and second sealing members 27a and 27b may, for example, be made of silicone.

Referring to FIG. 1, again, the scan board 32 is mounted on the other side 22d of the chassis base 22. The scan board 32 includes a first rigid circuit 132 mounted on the chassis base 22 (refer to FIG. 1) and a first flexible circuit 232 connected to the scan electrodes 42 (refer to a connection structure of the sustain electrodes of FIG. 3). In addition, the scan board 32 further includes scan buffer boards 33. The scan buffer boards 33 are connected between the first flexible circuits 232 and the first rigid circuit 132.

Since the scan board 32 is mounted on the chassis base 22 in substantially the same structure as the sustain board 31, the description on the same structure is omitted, and the different structure from the sustain board 31 will be described. Specifically, the scan board 32 and the scan buffer board 33 are mounted on the chassis base 22 using the bosses 24 and the set screws 25 similarly to the sustain board 31.

Unlike the sustain electrodes 41, the scan electrodes 42 are selectively supplied with the driving voltages in order to select the discharge cell DC. Accordingly, the first flexible circuit 232 includes second circuit patterns 232a connected to the plurality of scan electrodes 42 (refer to FIG 2). Flexible terminals 232d connected to the second circuit patterns 232a are separately formed and connected to the scan electrodes 42.

The scan buffer board 33 includes a second rigid circuit 133 and a second flexible circuit 233. The second rigid circuits 133 are mounted on the chassis base 22 between the first flexible circuits 232 and the first rigid circuit 132 and connected to the first flexible circuits 232. The second flexible circuits 233 are connected to the second rigid circuits 133 to be connected to the first rigid circuit 132. The scan electrodes 42 are connected to the first rigid circuit 132 through the first flexible circuits 232, the second rigid circuits 133, and the second flexible circuits 233.

The partly rigid and partly flexible printed circuit board 30 having a connection structure between the rigid circuit 131 and the flexible circuit 231, which is applied to the sustain board 31, can be similarly applied to the scan board 32 and the scan buffer board 33.

The rigid terminals 131 c and the flexible terminals 231 d of the sustain board 31, and the conductive balls CBs interposed therebetween may be similarly applied to the connection structure among the scan board 32, the first and second rigid circuits 132 and 133, and the first and second flexible circuit 232 and 233. Accordingly, detailed description will be omitted.

As described above, when the sustain board 31, the scan board 32, and the scan buffer board 33 are applied to the partly rigid and partly flexible printed circuit board 30, connection reliability among the sustain and scan electrodes 41 and 42 and the partly rigid and partly flexible printed circuit board 30 is improved, and the EMI noise is further reduced.

As described above, according to the plasma display device of embodiments of the invention, the partly rigid and partly flexible printed circuit board is mounted on the chassis base and connected to the display electrodes of the plasma display panel, thereby improving the connection reliability between the display electrodes and the partly rigid and partly flexible printed circuit board and reducing EMI noise. In addition, the partly rigid and partly flexible printed circuit boards are connected to each other, thereby improving the connection reliability between the partly rigid and partly flexible printed circuit boards and further reducing the EMI noise. In addition, as a result of using a partly rigid and partly flexible printed circuit board , and the number of components is reduced, and cost is thus reduced.

It will be appreciated that the above embodiments of the invention have been described in terms of including a partly rigid and partly flexible printed circuit board. Therefore, embodiments of the invention could include a printed circuit board including a rigid portion and a flexible portion. More generally, embodiments of the invention could include a printed circuit board including a first portion and a second portion, wherein the second portion is flexible or more flexible than the first portion. In addition, embodiments of the invention could include a printed circuit board including a first portion and a second portion, wherein both the first and second portions are flexible.

While embodiments of the invention have been described in connection with what is presently considered to be practical, it is to be understood that the invention is not limited to the disclosed embodiments, but, on the contrary, is intended to cover various modifications and equivalent arrangements.

## Claims

1. A plasma display device comprising:
a plasma display panel configured to display an image and having display electrodes;
a chassis base configured to support the plasma display panel; and
a partly rigid and partly flexible printed circuit board mounted on the chassis base on a side opposite the plasma display panel and connected to the display electrodes of the plasma display panel.

2. A plasma display device according to claim 1, wherein the partly rigid and partly flexible printed circuit board comprises:
a rigid circuit mounted on the chassis base; and
a flexible circuit connected to the rigid circuit and to the display electrodes of the plasma display panel.

3. A plasma display device according to claim 2,
wherein the rigid circuit includes rigid terminals formed on an end of the plasma display panel, and
wherein the flexible circuit includes flexible terminals facing the rigid terminals.

4. A plasma display device according to claim 3, wherein the rigid circuit has a curved shape in order to prevent interference with the flexible circuit.

5. A plasma display device according to claim 3 or 4, further comprising an anisotropic conductive film interposed between the rigid circuit and the flexible circuit to connect the rigid terminals and the flexible terminals.

6. A plasma display device according to any one of claims 3 to 5, wherein the rigid circuit includes:
a substrate on which a circuit pattern is formed; and
a plurality of rigid terminals connected to the circuit pattern and exposed at an end of the substrate,
and wherein the flexible circuit includes:
two films between which a circuit pattern is formed; and
a plurality of flexible terminals connected to the circuit pattern and exposed to one of the films, and
wherein the rigid terminals and the flexible terminals have a predetermined pitch, face each other, and are connected to each other with conductive balls disposed therebetween.

7. A plasma display device according to any one of claims 2 to 6, wherein a plurality of flexible circuits are connected to the rigid circuit.

8. A plasma display device according to claim 7, wherein the display electrodes include sustain electrodes and scan electrodes, and wherein the flexible circuit comprises a first circuit pattern connected to the sustain electrodes.

9. A plasma display device according to claim 7 or 8,
wherein the display electrodes comprise the sustain electrodes and the scan electrodes, and
wherein the flexible circuit comprises second circuit patterns connected to the scan electrodes.

10. A plasma display device according to claims 1 to 9,
wherein the display electrodes comprise sustain electrodes and scan electrodes,
wherein the chassis base has a substantially rectangular shape with two facing long sides and first and second facing short sides substantially perpendicular to the long sides, and
wherein the partly rigid and partly flexible printed circuit board comprises:
a sustain board comprising a rigid circuit and mounted on the first short side of the chassis base and connected to the sustain electrodes using flexible circuits; and
a scan board comprising another rigid circuit and mounted on the second short side of the chassis base and connected to the scan electrodes using additional flexible circuits.

11. A plasma display device according to claim 10, wherein the scan board further comprises a scan buffer board connected between the additional flexible circuits and the rigid circuit of the scan board.

12. A plasma display device according to claim 11, wherein the scan buffer board comprises:
another rigid circuit mounted on the chassis base between the additional flexible circuits and the rigid circuit of the scan board and connected to the additional flexible circuits; and
another flexible circuit through which the rigid circuit of the scan buffer board is connected to the rigid circuit of the scan board.
